# EUROPEAN PATENT APPLICATION

(11) **EP 0 867 537 A1**
(43) Date of publication of application: **30.09.1998**
(21) Application number: 98301762.5
(22) Date of filing: 10.03.1998
(51) Int. Cl.: C30B 25/02

(54) **Method for the production of low-cost isotopically engineered diamond anvils**

(30) Priority: 24.03.1997 US 822855
(71) Applicant: GENERAL ELECTRIC COMPANY, Schenectady, NY 12345 (US)
(72) Inventor: Anthony, Thomas Richard, Schenectady, New York 12309-2154 (US); Banholzer, William Frank, Shaker Hts, OH 44122 (US); Peters, Herbert Clark, Ballston Spa, New York 12020-2703 (US)
(74) Representative: Szary, Anne Catherine, Dr.

(57) **Abstract**

The present invention relates to a method for the production of low-cost, high strength engineered isotropic diamond anvils which overcome present limitations on pressure measurements at a cost only slightly higher than the cost of presently available natural abundance diamond anvils.

## Description

### BACKGROUND

The present invention relates to a method for the production of low-cost isotopically engineered diamonds that are particularly appropriate for use in a so-called "diamond anvil".

A diamond anvil is an apparatus that allows direct viewing or monitoring of a material that is highly compressed between two surfaces. Scientific American, Vol. 250 (April, 1984) pp. 54-62. Diamond anvil apparatus includes a pair of circularly shaped diamonds coaxially arranged with facing, plane parallel bearing surfaces and a device for applying a force to these diamonds tending to press the bearing surfaces together. Pressures higher than those at the center of the earth have been achieved with this apparatus.

The generation of high pressure for research and development exploratory work has been influenced heavily by apparatus design and strength of materials. Professor Bridgman of Harvard found that he could reach pressures of about 100 Kbar by squeezing thinned samples between flat blocks. This work led to the development of the famous Bridgman anvil. Bridgman recognized that if harder materials, such as sintered diamonds, were used for anvils, even higher pressures could be reached. The "Bridgman anvil", circa 1905, used tungsten carbide for one or both of the pressure producing surfaces and was opaque to visible wavelength radiation.

In 1959, Weir, Lippincott, Van Valkenberg and Bunting, of the National Bureau of Standards and, independently, Jamieson, Lawson and Nachtrieb of the University of Chicago, fabricated the first diamond anvils for high pressure materials investigation. This started a revolution in high pressure work. Diamond anvil cells are now commonly used throughout the world in high pressure research.

Conventionally, diamond anvil apparatus has employed circularly shaped, brilliant cut diamonds arranged coaxially with their top or bottom facets facing each other and serving as the bearing surfaces that apply a force to the test material. This force, tending to press the bearing surfaces together, and which may be generated by a hydraulic press or a screw device, etc., is applied in the axial direction to the opposite facing surfaces of the two diamonds.

The diamond anvil cell, used for microscopic studies, divides into halves, each holding a brilliant-cut, natural (99% 12C-1% 13C) diamond (the diamond anvils). Bolted together, these halves sandwich between them (and between the anvils) a thin, metal gasket with a chamber smaller than a pinhole that contains a material sample, pressure sensor, and pressure medium. The material sample might be a bit of powder, a tiny crystal, a fluid/mineral mixture, or a combination of these. The pressure medium is a fluid that distributes pressure evenly over the surfaces of the sample and pressure sensor. The resistively or laser heated diamond anvil cell, with its wide range of hydrostatic or quasi-hydrostatic pressures (0-25 Gpa) and temperatures (10-1200 °K), is the most important and versatile research tool for studying materials under high-pressure, high-temperature conditions.

Diamond anvil cells are the most important means of generating high pressures. They allow a wider variety of measurements at higher pressures (up to several hundred Gpa) than any other type of apparatus does. The fact that the diamond anvils are transparent to infrared, visible, and near ultraviolet light, as well as to x-rays, makes them flexible enough to allow measurements ranging from infrared, Raman, and fluorescence spectroscopy to x-ray diffraction. To achieve well controlled temperatures, resistance heaters are placed all around the diamond anvils, or the entire cell is placed in a resistively heated chamber within a vacuum container. Alternatively, the contents of the cell may be heated with a laser beam. Temperatures are measured with thermocouples.

In diamond anvil cell studies, accurate pressure measurements are vital. To take a pressure reading, a researcher usually directs a laser beam through the diamond anvils to the sample chamber and observe the frequency changes in the sensor's spectral lines. The use of a pressure sensor is required with the diamond anvil cell's chamber because the pressure at the sample cannot be determined accurately from the applied force. To be practical, the pressure sensor must be chemically inert and easy to use, and it must provide a rapid measurement. For diamond anvil cells at room temperature, pressures are usually measured from the shifts in the fluorescence lines of ruby or samarium doped yttrium aluminum garnet or similar materials.

It is also possible to use Raman spectroscopy for pressure measurements in diamond cells, although up to now, it has played only a small role compared with fluorescence. Raman spectroscopy refers to the frequency shift of scattered light from a solid or a molecule that is vibrated by laser light. Vibrational frequencies differ for different isotopes and change with pressure or temperature. With Raman spectroscopy, shifts in a sample's vibrational frequencies because of pressure or temperature are measured directly by measuring the corresponding frequency changes in the scattered light.

In order to prevent the test material from being squeezed out of the space between bearing surfaces, a malleable gasket is arranged between the two diamonds. This gasket has a central opening for the test material and comes in contact with the edges of the bearing surfaces on opposite sides. When the bearing surfaces of the two diamonds are pressed toward each other, the gasket is compressed permitting the diamonds to approach each other and apply a force to the test material.

Due to enormous and often unequal forces generated during a test, the sharp edges of the bearing surfaces tend to fracture or crack. Such fractures, when they occur, prevent the even application of force to the test material.

Efforts have been made to reduce the fragility of the diamond edges by providing one or more rows of bevels adjacent to the bearing surface edges so that included angles are not as sharp. See U.S. Pat. No. 4,776,223. However, even this configuration has angular edges which are relatively fragile.

The diamond used in present anvil apparatus is frequently synthetic. Synthetic diamonds are generally manufactured by one of two processes. The first is vapor phase synthesis as represented by chemical vapor deposition (CVD); the second is high pressure synthesis which comprises bringing powders of graphite, diamond, etc., under high temperature and high pressure to obtain crystalline diamond therefrom. The high pressure synthesis are further classified into three methods as follows:
1. Impact process: the process comprises bringing the starting powder instantaneously under high pressure by applying impact which is generated by, for example, the explosion of explosives and the collision of a body accelerated to a high speed. In this manner, granular diamond can be obtained by directly converting the starting powder material having a graphite structure into a powder composed of grains having a diamond structure. This process is advantageous in that no press as is required in the two other processes is necessary; however, there is difficulty in controlling the size of the resulting diamond products.
2. Direct conversion process: the process comprises maintaining the starting graphite powder under a high static pressure of from 13 to 16 GPa and a high temperature of from 3,000 to 4,000 degrees Centigrade in a sealed high pressure vessel. By thus realizing stability conditions for diamond, the graphite powder undergoes direct phase transition from graphite into diamond, through graphite decomposition and structural reorganization into diamond.
3. Flux process: the process is similar to the aforementioned direct process in that a static pressure and high temperature are applied to the starting material . In this process, however, fluxes such as Ni and Fe are utilized to allow the reaction to occur under lower pressure and temperature conditions as compared to those employed in direct conversion process. That is, in the present process, the entire atomic rearrangement which occurs in the conversion process is accelerated by the use of a flux. Specifically, this process comprises charging the flux inside a high pressure vessel in such a manner that it may be enclosed in the starting powder material, i.e., high purity graphite, and then, heating them wholly under a pressure of from 4 to 6 GPa in the temperature range of from about 1,500 to 2,000 degrees Centigrade. Thus , the flux turns into a solution and graphite is then dissolved therein to give a saturated solution. Because the pressure inside the high pressure vessel at this point is maintained in the stability range for diamond, the solubility for graphite far exceeds that for diamond. Thus, what happens inside the vessel is diamond precipitation and dissolution of graphite into the flux.

Among the high pressure synthesis processes described above, the flux process is widely used because it enables single crystal diamonds as large as several millimeters in size. This was realized by the advent of apparatuses such as a belt-type apparatus and an anvil apparatus. In fact, such high quality single crystals are not feasible by vapor phase synthesis.

The aforementioned high pressure synthesis is somewhat limited by the presence of a pressure member (anvil) made from cemented carbide. Even the National Bureau of Standards (NBS) high pressure cells achieved pressures of only 500 Kbar using brilliant cut diamond anvils of about one-third carat, the culets being polished to produce a flat of about 0.002 mm² in area. This flat generally is the (100) plane, since the normal plane of a brilliant cut is (100).

More recently, pressures approaching 5,000 Kbar, equal to the pressure at the center of the earth, have been reported by Ruoff et al, "Optical Properties of Diamond at Pressures Comparable to the Earth's Center", Proceedings of the Second International Conference, New Diamond Science and Technology, Edited by Messier et al, Sep. 23-27, Washington, D.C. Materials Research Society, Pittsburgh, Pa., the disclosure of which is expressly incorporated herein by reference. Still higher pressures are desired, requiring stronger diamond anvils. To date, experiments performed at 4,000 Kbar and higher result in the expensive anvils being broken in virtually every run.

High pressure researchers have long wanted to use a small chip of natural isotopic abundance diamond (99% ¹²C) as a pressure sensor because of its inertness as well as the fact that diamond is nature's best spring -- i.e., its Raman shift with increasing pressure is well-behaved to pressures higher than that of any other material. Unfortunately, present diamond anvils are also comprised of natural isotopic abundance diamond. The Raman line from the anvils through which the laser probe must pass will therefore overlap the Raman line from the diamond sensor chip because the stresses in the anvil vary from zero up to the pressure in the diamond anvil cell. Hence, the Raman line from the anvil is very broad and overlaps with the Raman line from the natural diamond sensor chip.

To get around this problem, the current state-of-the-art pressure sensor utilizes a small chip of 13C diamond as the sensor. Since at zero pressure, the Raman lines from natural and 13C diamond do not overlap, the Raman line of the 13C sensor can be measured through the natural diamond anvils. Ultimately, however, the Raman line from the 13C sensor increases in frequency with increasing pressure and finally begins to overlap with the Raman lines of the anvil. This overlap again confounds pressure measurements at higher pressures, especially above 25 GPa.

Thus, there exists the need in the art for an apparatus and pressure sensor that will work accurately at extremely high pressures.

The present invention accomplishes this goal by providing a method for manufacturing relatively low-cost isotopically engineered diamond crystals. Commonly-assigned United States Patent No. 5,419,276 discloses a method for preparing single crystal diamond of very high chemical and isotopic purity by depositing a layer of diamond on a substrate by chemical vapor deposition methodology using a feed mixture of hydrogen and a hydrocarbon containing isotopically pure carbon-12 or carbon-13. The thus-deposited diamond layer is removed from the substrate and converted to single-crystal diamond by diffusion under high pressure through a metallic catalyst/solvent to a region containing a diamond seed crystal. The patent reports the production of single crystal 0.95 carat diamond which analyzed to 99.93% carbon being the ¹²C isotope when made from methane having an isotope distribution of 99.96% ¹²C and 0.04% ¹³C. The room temperature conductivity of this single crystal product is reported at 31.5 watt/cm °K.

It has now been determined by the present inventors that an isotopically engineered gemstone, specifically diamond having approximately 3-20% ¹³C, avoids the problem of Raman line broadening and thereby provides more accurate pressure measurements than anvil cells which are currently in use. In addition, since the disclosed diamonds are of only partial isotopic purity, they may be produced in accordance with the present invention for a fraction of the cost associated with the preparation of more highly purified diamonds.

### SUMMARY OF THE INVENTION

GE synthetic diamond gemstones have been shown to be mechanically stronger than their natural counterparts and therefore make superior diamond anvils. Diamond anvils are routinely broken as researchers strive for higher and higher pressures. An anvil replacement market has therefore developed, Moreover, the world is running out of the strain-free Type IIA natural diamonds that have been used in the past as diamond anvils. Thus, the need for alternative diamond anvils is great.

Recently, a revolutionary new method of precisely measuring the pressure in a diamond anvil cell was revealed in a paper in press in the Journal of Applied Physics and co-authored by Dr. Thomas R. Anthony, "The Diamond ¹³C/¹²C Isotope Raman Pressure Sensor System for High Temperature/Pressure Diamond Anvil Cells ) with Aqueous and Other Chemically Reactive Samples", D. Schiferl, M.F. Nicol, J.M. Zaug, S.K. Sharma, T.F. Cooney, S.Y. Wang, T.R. Anthony and J.F. Fleischer, (submitted to J.APPL.PHYS., 1996) (hereinafter "The Diamond Isotope ¹³C/¹²C paper"). This new method of pressure measurement uses the shift in the Raman 5 spectrum with pressure of a thin film of ¹³C diamond in a diamond anvil cell whose anvils are composed of natural diamond (99% ¹²C & 1% ¹³C). Because the Raman lines from natural diamond and ¹³C diamond are separated by 50 cm⁻¹, the ¹³C diamond line from the sensor inside the pressure cell can be measured without any interference from the Raman lines of the anvil. This technique provides the first means to measure the pressure precisely (± 0.3 GPa) at most temperatures (10-1200 K') and at most pressures (O-25 GPa) for any sample compatible with an externally heated diamond anvil cell.

Unfortunately, as shown in Figure 4 in The Diamond ¹³C/¹²C Isotope paper, this technique breaks down above 25 GPa because of the overlap of Raman lines from the anvil and the ¹³C chip in the cell as the lines shift with pressure. This breakdown occurs because the diamond anvil sees pressures ranging from 0 to 25 GPa because of pressure gradients within the diamond anvil. This pressure spread, in turn, spreads the Raman line from the anvil which eventually overlaps with the ¹³C Raman line from the sensor chip whose line has been shifted upwards with increasing pressure.

The confounding affects of the broadened Raman lines of the anvil could be avoided if one were able to use a ¹³C diamond anvil with a ¹²C diamond sensor chip. With this arrangement, the Raman frequency of the sensor would always be above the Raman lines from the anvil and there would be no limit to the pressure that could be measured with this technique. However, as stated in The Diamond ¹³C/¹²C Isotope paper, "[u]nfortunately, this approach is prohibitively expensive at present", because of the very high price of ¹³C carbon.

The object of this invention is to provide a method for producing diamond anvils which overcome the present limitations on pressure measurements at a cost only slightly higher than the present cost of natural composition diamonds.

### DETAILED DESCRIPTION OF THE INVENTION

The present invention comprises a method for the production of low cost high strength engineered isotropic diamond anvils and represents a significant product cost improvement over the suggestions given in The Diamond ¹³C/¹²C Isotope paper.

Figure 1, taken from Isotropic Composition of Diamond by W.F. Banholzer and T.R. Anthony, Thin Film Solids, 111,12 222 (1992), shows the shift of the Raman line of diamond versus the isotopic composition of the diamond. To avoid overlap of the Raman lines from the sensor and the anvils, it is only necessary that the Raman line of the anvil is slightly lower than the Raman line of the sensor.

Consequently, there is no need as stated in The Diamond ¹³C/¹²C Isotope paper, for the diamond anvil to be made of pure ¹³C carbon. Instead, the diamond anvil need only be comprised of an isotopic alloy containing from 3 to 20% ¹³C carbon. This shift in isotopic composition is sufficient to shift the Raman line from the anvil downwards by 3 to 13 cm⁻¹ relative to the sensor. Since the breadth of the Raman line at these compositions (2-3 cm⁻¹ FWHM) is less than the shift and because the ¹²C sensor is always subjected to an equal or greater pressure than any part of the anvil, the line from the ¹²C sensor will always remain above the broadened Raman lines from the anvil. Hence, the high pressure limitation of 25GPa noted in The Diamond ¹³C/¹²C Isotope paper is broken and the diamond anvil cell and associated sensor can measure all pressures, no matter how high.

By using a low concentration ¹³C isotopic alloy in place of a pure ¹³C anvil, the material cost of the anvil can be reduced between 5-20 times, making what was previously prohibitively expensive, as stated in The Diamond ¹³C/¹²C Isotope paper, no longer nearly as expensive.

Previously, diamond gem stones have been grown from diamond feed stock. With isotopic gemstones, a large portion of the cost results from the inefficiency of converting isotopically pure methane to isotopically pure CVD diamond. The overall efficiency of this process is only a few percent. Isotopically pure ¹³C methane is very expensive. For example, a recent quote from Cambridge Isotopes for ¹³CH₄ was $800/liter. To make one carat of ¹³C carbon, 0.373 liters of isotopically pure methane at a cost of $300 is required if the conversion efficiency is 100%. However, the actual current process of first producing ¹³C CVD diamond and then growing HPHT ¹³C gemstones has an overall process conversion efficiency of only 1%. This low conversion efficiency increases the material costs of one carat of ¹³C diamond to $30,000/carat.

By using an dilute ¹³C isotopic alloy in place of pure ¹³C for the diamond anvils, this $30,000 cost can easily be reduced to $1500-$6000 per carat of anvil. In accordance with another aspect of the disclosed method, this material cost may be further reduced to between $40-$150 per carat of anvil.

For many years, the common belief in the HP/HT diamond growth field was that diamond gemstones could only be successfully grown from diamond feedstock. The reasoning behind this belief is that if graphite is used as a feed stock, the 50% volume change on conversion of graphite to diamond would disrupt the growth conditions in the cell enough that large defect-free gems could not be grown. Rather multiple and secondary nucleation induced by pressure/temperature changes generated by large cell volume changes would occur and a large gem stone could not be obtained from a process utilizing graphite feedstock.

It has now been determined by the present inventors that isotopic diamond gem stones may be grown directly from isotopically pure graphite feedstock and that the material price of a one-carat isotopically pure diamond gemstone could be reduced from $30,000 to less than $800. The method of producing isotopically pure graphite used in this process is described in a paper co-authored by Dr. Thomas R. Anthony et al., "Graphite Rod Precursors For Isotopically Pure Fullerenes and Diamond", Carbon, 34(11)1323-1328 (1996). The much lower cost of this process is a direct result of the much higher efficiency with which ¹³CH₄ can be converted to isotopically pure graphite (-50% efficiency) than to CVD diamond (∼2% efficiency).

In contrast, previous work has used diamond alone as the feedstock for HP/HT gemstone growth. For purposes of making the engineered isotopic diamond anvils described above, a second aspect of the present invention uses a combination of diamond and graphite as the feedstock for diamond gem growth. The diamond feedstock is natural isotopic abundance diamond that can be obtained from current production. The graphite feedstock may be either pure ¹³C graphite or enriched ¹³C graphite made by the method described in "Graphite Rod Precursors For Isotopically Pure Fullerenes and Diamond" by T.R. Anthony et al., supra. Since 80-95% of the feedstock would be diamond, volume changes in the cell during diamond growth are minimized and the yield of gem stones from the process is high. The material cost of ¹³C for the process can be kept below $150/carat because of the relatively low cost of ¹³C graphite when compared to ¹³C CVD diamond.

Table 1 presents the material costs of an engineered isotopic diamond anvil before and after the invention described herein.

**TABLE I:**

| Cost Reduction of an Engineered Isocopic Diamond Anvil from this Invention. | | |
|---|---|---|
| | Before Invention | After Invention |
| Material Cost per Carat | $30,000 | $150 |
| Material Cost/Selling Price (%) | 99 | 3 |

## Claims

1. A method for preparing an improved diamond anvil, said method comprising the steps of
selecting an isotopically engineered carbon-containing composition as a starting material;
preparing isotopically engineered diamond or graphite from said starting material;
converting said isotopically engineered diamond or graphite to single crystal diamond comprising from about 3 - 20 atomic percent ¹³C and from about 80 - 97 atomic percent ¹²C; and
using said single crystal diamond to make said diamond anvil.

2. A method according to claim 1, wherein said starting material is converted into said isotopically engineered diamond or graphite using a chemical vapor deposition process.

3. A method according to claim 1, wherein said isotopically engineered diamond or graphite is converted to said single crystal diamond using a high temperature/high pressure process.

4. A method according to claim 1, wherein isotopically engineered graphite is converted to said single crystal diamond.

5. A method according to claim 4, wherein said starting material is converted into said isotopically engineered diamond or graphite using a chemical vapor deposition process.

6. A method according to claim 5, wherein said isotopically engineered diamond or graphite is converted to said single crystal diamond using a high temperature/high pressure process.

7. An improved method for measuring the pressure in a diamond anvil cell wherein the natural abundance diamond anvil is replaced by an isotopically engineered diamond anvil comprising from about 3 - 20 atomic percent ¹³C and from about 80 - 97 atomic percent ¹²C carbon such that the Raman line width of the isotopically engineered diamond is always less than the Raman-line downshift from the Raman line position of the natural abundance diamond sensor of said diamond anvil cell.
